# EUROPEAN PATENT APPLICATION

(11) **EP 4 213 187 A1**
(43) Date of publication of application: **19.07.2023**
(21) Application number: 22151143.9
(22) Date of filing: 12.01.2022
(51) Int. Cl.: H01L 21/56, H01L 21/683, H01L 23/00, H01L 23/31, H01L 23/544, H01L 23/64, H01L 23/538

(54) **ELECTRONIC PACKAGE AND METHOD FOR MANUFACTURING THE SAME**

(71) Applicant: Nexperia B.V., 6534 AB Nijmegen (NL)
(72) Inventor: Tang, Qingyuan, Dongguan, 523750 (CN); Zhao, YuJun, Dongguan, 523750 (CN)
(74) Representative: Pjanovic, Ilija

(57) **Abstract**

Aspects of the present disclosure relate to an electronic package and a method for manufacturing the same. The electronic package comprises a semiconductor die having a first surface and an opposing second surface, the semiconductor die having a circuit integrated thereon, wherein each of the first surface and the second surface has a respective terminal arranged thereat, the terminals being electrically connected to the circuit; a conductive element spaced apart from the semiconductor die and having a top surface and a bottom surface; a body of solidified molding compound at least partially encapsulating the semiconductor die and the conductive element, said body having a top side facing the first surface and a bottom side facing the second surface; a first package terminal at the top side that is electrically connected to the terminal at the first surface, and a second package terminal at the top side that is electrically connected to the top surface of the conductive element, wherein the conductive element is separately formed from the first package terminal and the second package terminal; and a conductive layer electrically connecting the bottom surface of the conductive element to the terminal arranged on the second surface of the semiconductor die.

## Description

Aspects of the present disclosure relate to an electronic package and a method for manufacturing the same.

Electronic components, such as semiconductor dies, may be arranged inside an electronic package to protect said electronic components from external damages, for example due to mechanical stress. For example, in a molded electronic package, an electronic component can be partially or fully encapsulated by a body of solidified molding compound, thereby protecting said electronic component.

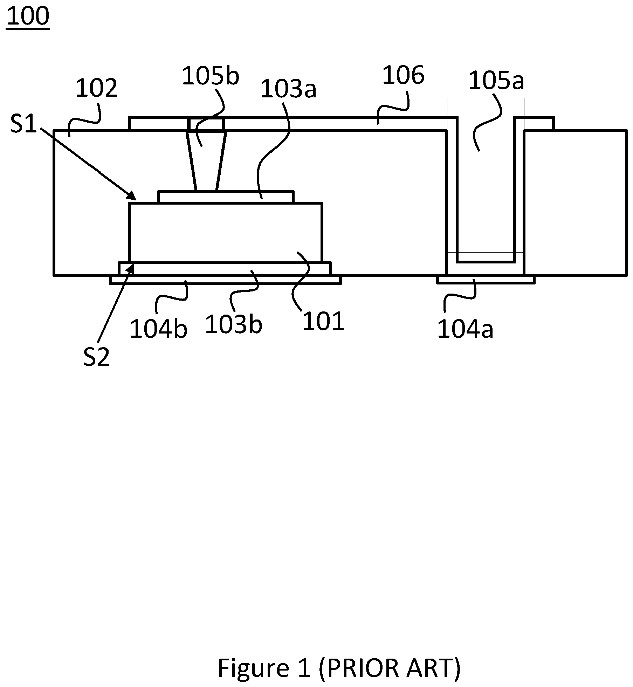

Figure 1 shows a cross-sectional view of an electronic package 100 known in the art. Electronic package 100 comprises a semiconductor die 101 that is encapsulated by a body of solidified molding compound 102. Semiconductor die 101 has a circuit integrated thereon, the circuit comprising a first terminal and a second terminal that are arranged at a first surface S1 and a second surface S2 of semiconductor die 101, respectively. On first surface S1, a first metal layer 103a is arranged that is electrically connected to the first terminal of the circuit. Similarly, on second surface S2, a second metal layer 103b is arranged that is electrically connected to the second terminal of the circuit. The circuit integrated on semiconductor die 101 may be a two-terminal device, such as a diode.

Electronic package 100 further comprises a first conductive contact 104a and a second conductive contact 104b arranged on a same side of the package and enabling external access to the first and second terminal of the circuit, respectively. Second conductive contact 104b is arranged directly on second surface S2 of semiconductor die 101, or on corresponding metal layer 103b.

According to known methods for manufacturing electronic package 100, first conductive contact 104a is electrically connected to the first terminal of the circuit by forming a first recess 105a and a second recess 105b in body of solidified molding compound 102, and forming a conductive layer 106 electrically connecting first conductive contact 104a to first surface S1 of semiconductor die 101, or to corresponding metal layer 103a.

First recess 105a and second recess 105b are typically formed by laser drilling body of solidified molding compound 102. However, the process of laser drilling may take a substantial amount of time, in particular for first recess 105a which must extend through body of solidified molding compound 102 to enable access to the first terminal through first conductive contact 104a and conductive layer 106.

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, a method for manufacturing an electronic package is provided. The method comprises the step of: a) providing a carrier substrate having arranged thereon a semiconductor die having a first surface and an opposing second surface, the semiconductor die having a circuit integrated thereon, wherein each of the first surface and the second surface has a respective terminal arranged thereat, the terminals being electrically connected to the circuit, and wherein the second surface is arranged facing the carrier substrate, and a conductive element spaced apart from the semiconductor die and having a top surface and a bottom surface, wherein the bottom surface is arranged facing the carrier substrate. The method further comprises the steps of b) applying a molding compound and allowing said molding compound to solidify, thereby forming a body of solidified molding compound that at least partially encapsulates the semiconductor die and the conductive element, said body of solidified molding compound having a top side facing the first surface and a bottom side facing the second surface, and c) performing top side processing and bottom side processing.

The top side processing comprises: c11) in so far as the top surface of the conductive element or the terminal at the first surface of the semiconductor die is encapsulated by the body of solidified molding compound, removing a portion of the body of solidified molding compound for exposing said top surface or terminal, respectively, and c12) forming a first package terminal at the top side that is electrically connected to the terminal at the first surface, and forming a second package terminal at the top side that is electrically connected to the top surface of the conductive element. The bottom side processing comprises: c21) removing the carrier substrate to expose the bottom side of the body of solidified molding compound, the second surface, and the bottom surface of the conductive element, and c22) arranging a conductive layer for connecting the bottom surface of the conductive element to the terminal arranged on the second surface of the semiconductor die.

By providing one or more conductive elements according to the present disclosure, in particular prior to applying the molding compound, the amount of solidified molding compound to be removed during top side and bottom side processing is minimized. As such, the efficiency of manufacturing electronic packages is greatly improved. Furthermore, the conductive element enables the terminal at the second surface of the semiconductor die to be electrically connected to a package terminal at a top side of the electronic package.

The terminal arranged at the first surface of the semiconductor die may comprise one or more conductive studs.

Using conductive studs eliminates the need for exposing the semiconductor die directly and reduces stress on the semiconductor die during manufacturing. Furthermore, conductive studs remove the need for special metallization on the semiconductor die. For example, a die with copper studs can be used to form a copper-to-copper interconnection with a copper first package terminal, in which case an aluminum metallization can be used on the die.

The body of solidified molding compound may fully encapsulate the semiconductor die. In that case, step c11) may comprise removing a first portion of the body of solidified molding compound at the top side to enable forming the first package terminal electrically connected to the terminal at the first surface of the semiconductor die. In some embodiments, removing the first portion of the body of solidified molding compound may be performed by laser drilling or plasma etching.

Additionally or alternatively, the body of solidified molding compound may fully encapsulate the conductive element, in which case step c11) may further comprise removing a second portion of the body of solidified molding compound at the top side to enable forming the second package terminal electrically connected to said conductive element.

In some embodiments, a length of the conductive element, along a direction from the bottom surface thereof to the top surface thereof, is greater than a thickness of the semiconductor die along said direction. Removing the second portion of the body of solidified molding compound may be performed by grinding the top side, thereby exposing a portion of said conductive element at the top side.

Since the conductive element extends beyond the semiconductor die, upon grinding the top side of the body of solidified molding compound, the conductive element is exposed while the semiconductor die, including optional studs, remains fully encapsulated by the body of solidified molding compound after the second portion of the body of solidified molding compound is removed. The conductive element then provides an indication of when the grinding process can be terminated to prevent applying mechanical stress to the semiconductor die, since the semiconductor die is not yet exposed at that stage. Furthermore, the grinding exposes the top surface of the conductive element and enables a package terminal to be arranged and electrically connected to the conductive element.

Removing the second portion of the body of solidified molding compound may be performed before removing the first portion of the body of solidified molding compound. Since the grinding can be performed relatively uniformly at the top side, the first portion of molding compound that is to be removed to expose the terminal at the first surface of the semiconductor die is minimized, allowing for a more efficient manufacturing process.

Alternatively to grinding, removing the second portion of the body of solidified molding compound may be performed by laser drilling or plasma etching.

Forming the first package terminal and the second package terminal may comprise arranging one or more corresponding intermediate layers, such as seed layers, and performing an electroplating process. In some embodiments, the intermediate layer(s) may comprise a different material composition compared to at least one of the conductive element, the first package terminal and the second package terminal.

Prior to step c22) during bottom side processing, the method may further comprise grinding the bottom side, thereby removing a portion of the semiconductor die at a side of the second surface thereof. This enables reducing a thickness of the electronic package by reducing a thickness of the semiconductor die. This thinning process may be advantageous compared to using thin semiconductor dies obtained from thin wafers, which have a higher risk of being damaged or broken, for example during transportation thereof, and typically require more advanced and more expensive processes to manufacture and handle wafers.

The bottom side processing may further comprise: c23) arranging a cover material encapsulating the conductive layer, wherein the cover material is preferably formed using a solidified molding compound or a solder mask.

The carrier substrate may have arranged thereon a plurality of groups, each group comprising a respective semiconductor die and a respective conductive element, for substantially simultaneously manufacturing a plurality of electronic packages. The plurality of groups may be arranged in a mutually spaced apart manner. In that case, the method may further comprise a step of singulating the plurality of electronic packages from one another. The step of singulating the plurality of electronic packages may comprise performing at least one of cutting, sawing, punching and drilling.

The conductive elements from the plurality of groups may be arranged in a frame or grid, and the conductive element of each group may be electrically connected to one or more conductive elements from one or more respective adjacent groups through conductive interconnection elements, such as tie bars. During the step of singulating the plurality of electronic packages, the electrical connection formed by the conductive interconnection elements may be broken.

Arranging a plurality of conductive elements on the carrier substrate as described above may be particularly useful for die alignment through location registration and reducing or preventing warpage. Furthermore, the interconnected conductive elements provide a bus line for efficient electroplating, for example tin electroplating, to enhance the solderability of the second package terminals of the plurality of electronic packages.

During step c12), each of the first and second package terminal corresponding to a respective electronic package among the plurality of electronic packages may be integrally formed with and/or electrically connected to a first package terminal or second package terminal corresponding to an adjacent electronic package among the plurality of electronic packages. During the step of singulating the plurality of electronic packages, the electrical connection between package terminals of the adjacently arranged electronic packages may be broken. This enables efficiently forming the package terminals of multiple electronic packages in fewer individual processing steps.

The method may further comprise forming one or more recesses in the body of solidified molding compound in a region in between adjacently arranged electronic packages. The first and/or second package terminal, or the electrical connection between package terminals of adjacently arranged electronic packages, may extend along a side wall of a corresponding recess among the one or more recesses. The singulation of the plurality of electronic packages may be performed along the one or more recesses.

Upon singulating the plurality of electronic packages as described above, a side-solderable surface is obtained for one or more package terminals of the electronic package. This may be particularly useful in automotive assembling processes that use automatic optical inspection techniques to determine the quality of solder joints after mounting of the electronic package.

The conductive element may comprise a metal or metal-coated post or pillar, such as a copper or copper-coated post or pillar. In some embodiments, the conductive element, when viewed in a direction from the bottom surface to the top surface, may have a substantially constant or increasing cross-sectional area along said direction.

The first package terminal, the second package terminal and/or the conductive layer may comprise at least one of copper, aluminum, silver, gold, and tin.

The method may further comprise plating the first package terminal and/or the second package terminal with a conductive solderable layer, such as tin, through an electroplating process.

The circuit integrated on the semiconductor die may comprise a diode, having a first terminal arranged at the first surface of the semiconductor die and having a second terminal arranged at the second surface of the semiconductor die. Alternatively, the circuit integrated on the semiconductor die may comprise a transistor, having a first and third terminal thereof arranged at the first surface of the semiconductor die, and having a second terminal thereof arranged at the second surface of the semiconductor die, wherein top side processing further comprises removing a portion of the body of solidified molding compound for exposing said third terminal, and forming a third package terminal at the top side that is electrically connected to the third terminal at the first surface.

According to another aspect of the present disclosure, an electronic package is provided, comprising a semiconductor die having a first surface and an opposing second surface, the semiconductor die having a circuit integrated thereon, wherein each of the first surface and the second surface has a respective terminal arranged thereat, the terminals being electrically connected to the circuit. Furthermore, the electronic package comprises a conductive element spaced apart from the semiconductor die and having a top surface and a bottom surface, and a body of solidified molding compound at least partially encapsulating the semiconductor die and the conductive element, said body of solidified molding compound having a top side facing the first surface and a bottom side facing the second surface. Furthermore, the electronic package comprises a first package terminal at the top side that is electrically connected to the terminal at the first surface, and a second package terminal at the top side that is electrically connected to the top surface of the conductive element, and a conductive layer electrically connecting the bottom surface of the conductive element to the terminal arranged on the second surface of the semiconductor die. The conductive element is separately formed from the second package terminal and the conductive layer.

The second package terminal may be electrically connected to the conductive element via an intermediate layer. Additionally or alternatively, the first package terminal may be electrically connected to the terminal at the first surface via an intermediate layer. In some embodiments, the intermediate layer may be a seed layer comprising a different material composition compared to at least one of the conductive element (8), the first package terminal (5a) and the second package terminal (5b). In some further embodiments, the first package terminal and/or the second package terminal may be electroplated terminals.

The terminal arranged at the first surface of the semiconductor die may comprise one or more conductive studs.

A length of said conductive element, along a direction from the bottom surface thereof to the top surface thereof, may be greater than a thickness of the semiconductor die along said direction.

The electronic package may further comprise a cover material encapsulating the conductive layer. For example, the cover material may comprise a solidified molding compound or a solder mask.

The electronic package may further comprise tie bars extending from the conductive element to a side surface of the electronic package.

The first and/or second package terminal may extend along a side wall of the body of solidified molding compound, said side wall preferably extending perpendicularly between the top side and the bottom side.

The conductive element may comprise a metal or metal-coated post or pillar, such as a copper or copper-coated post or pillar.

The conductive element, when viewed in a direction from the bottom surface to the top surface, may have a substantially constant or increasing cross-sectional area along said direction.

The first package terminal, the second package terminal and/or the conductive layer may comprise at least one of copper, aluminum, silver, gold, and tin.

The first package terminal and/or the second package terminal may be plated with a conductive solderable layer, such as tin.

The circuit integrated on the semiconductor die may comprise a diode, having a first terminal arranged at the first surface of the semiconductor die and having a second terminal arranged at the second surface of the semiconductor die. Alternatively, the circuit integrated on the semiconductor die may comprise a transistor, having a first and third terminal thereof arranged at the first surface of the semiconductor die, and having a second terminal thereof arranged at the second surface of the semiconductor die, the electronic package comprising a third package terminal at the top side that is electrically connected to the third terminal at the first surface.

Next, the present disclosure will be described in more detail with reference to the appended drawings, wherein:
Figure 1 is a cross-sectional view of an electronic package known in the art;
Figure 2A is a cross-sectional view of an electronic package according to an embodiment of the present disclosure;
Figure 2B is a simplified top view of the electronic package shown in Figure 2A;
Figures 3A-3I illustrate a method for manufacturing the electronic package of Figure 2 according to an embodiment of the present disclosure;
Figure 4 is a cross-sectional view of an electronic package according to another embodiment of the present disclosure;
Figure 5 is a top view of a frame of conductive elements and semiconductor dies for manufacturing a plurality of electronic packages according to an embodiment of the present disclosure;
Figure 6A is a cross-sectional view of electronic packages prior to singulation according to an embodiment of the present disclosure; and
Figure 6B is a top view of electronic packages prior to singulation according to an embodiment of the present disclosure.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

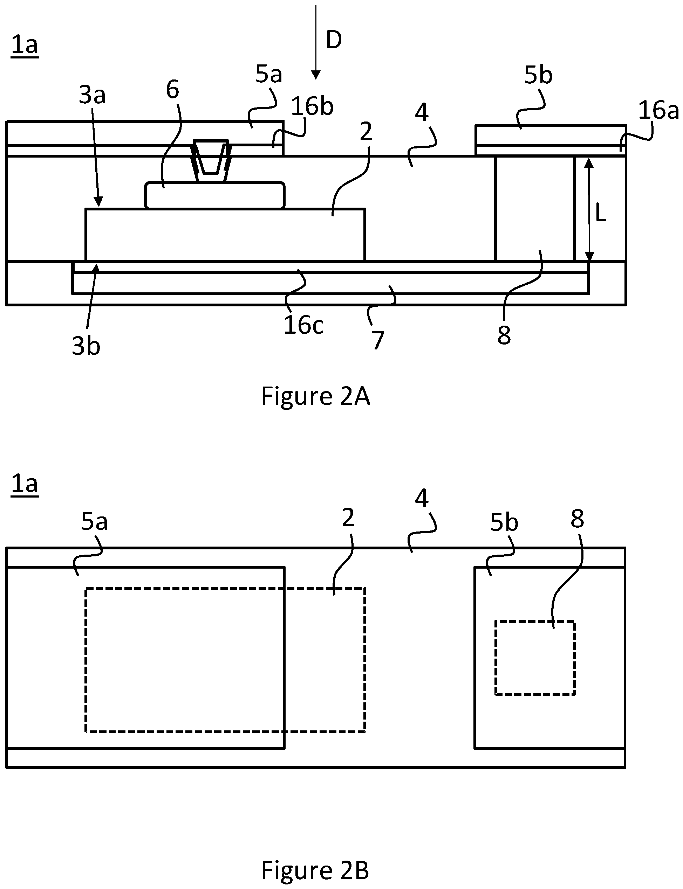

In Figure 2A, a cross-sectional view of an electronic package 1a according to an embodiment of the present disclosure is shown. Furthermore, Figure 2B shows electronic package 1a viewed from a direction D indicated in Figure 2A. It is noted that some components of electronic package 1a that are not visible from direction D are indicated with dashed lines in Figure 2B.

Electronic package 1a comprises a semiconductor die 2 having a circuit integrated thereon. The circuit may have circuit terminals that are electrically connected to terminals of semiconductor die 2. Semiconductor die 2 comprises a first circuit terminal arranged at a first surface 3a thereof, and a second circuit terminal arranged at a second surface 3b thereof. For example, the circuit may be a diode. The circuit terminals may for example be electrically accessible through a metal layer or a metal layer stack (not shown) of semiconductor die 2, as will be appreciated by a person skilled in the art. The first and second circuit terminal of semiconductor die 2 may be formed in said metal layer(s) of the metal layer stack.

Electronic package 1a further comprises a body of solidified molding compound 4 that encapsulates semiconductor die 2. Solidified molding compound 4 may provide rigidity to the structure of electronic package and may protect components encapsulated therein from being damage, for example due to mechanical stress.

Furthermore, electronic package 1a comprises a first package terminal 5a and a second package terminal 5b arranged at a same side of electronic package 1a. First package terminal 5a and second package terminal 5b may together define a mounting surface by which electronic package 1a can be mounted to an external surface, such as a printed circuit board (PCB).

First package terminal 5a can be formed of a conductive material, such as copper, and is electrically connected to the first terminal of the circuit integrated on semiconductor die 2. For example, first package terminal 5a is in electrical contact with a portion of a metal layer in the metal layer stack of semiconductor die 2 that is connected to the first terminal. Optionally, the first terminal of semiconductor die 2 comprises one or more conductive studs 6, for example a copper stud, and first package terminal 5a is electrically connected to said conductive stud(s) 6. Conductive stud(s) 6 may be electrically connected to a circuit terminal. For example, conductive stud(s) 6 may be arranged on the circuit terminal formed in the metal layer of semiconductor die 2. In so far as first surface 3a or conductive stud 6 is not exposed at a top side of solidified molding compound 4, first package terminal 5a may be partially arranged in a recess formed in solidified molding compound 4. The second terminal, at second surface 3b of semiconductor die 2, is electrically connected to a conductive layer 8, such as a back contact, that extends parallel to second surface 3b.

To be able to electrically connect the second terminal of semiconductor die 2 to second package terminal 5b, electronic package 1a comprises a conductive element 8, such as a copper pillar, extending between and electrically connected to second package terminal 5b and conductive layer 8. Although conductive element 8 is shown in Figures 2A and 2B as a conductive pillar in a rectangular block shape, the present disclosure is not limited thereto. For example, conductive element 8 may have alternative dimensions and shapes, such as a T-shape, a triangular shape, a trapezoidal shape, or the like.

Second package terminal 5b and conductive element 8 are formed separately from one another. Moreover, second package terminal 5b may be electrically connected to conductive element 8 via an intermediate layer 16a. For example, intermediate layer 16a may be a seed layer. The seed layer may be used to form second package terminal 5b using an electroplating process. In an example, conductive element 8 and second package terminal 5b may comprise copper, whereas intermediate layer 16a may comprise copper or a copper alloy, such as an alloy of copper and titanium, or an alloy of copper and titanium or tungsten. In other words, in some embodiments, intermediate layer 16 may comprise a material or material composition different from that of conductive element 8 and/or second package terminal 5b.

The above may similarly apply to first package terminal 5a and/or conductive layer 7. For example, first package terminal 5a may be electrically connected to conductive stud 6 (or the corresponding terminal of semiconductor die 2) via an intermediate layer 16b. Additionally or alternatively, conductive layer 7 may be electrically connected to conductive element 8 via an intermediate layer 16c.

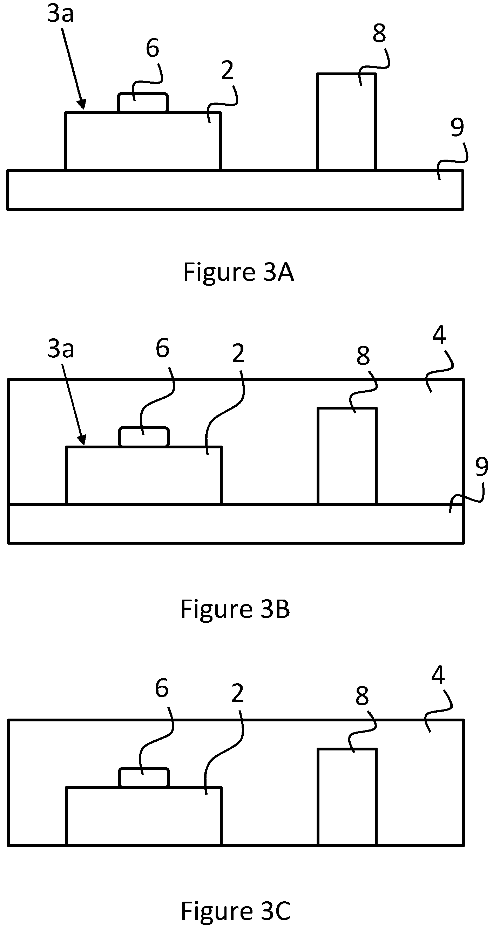

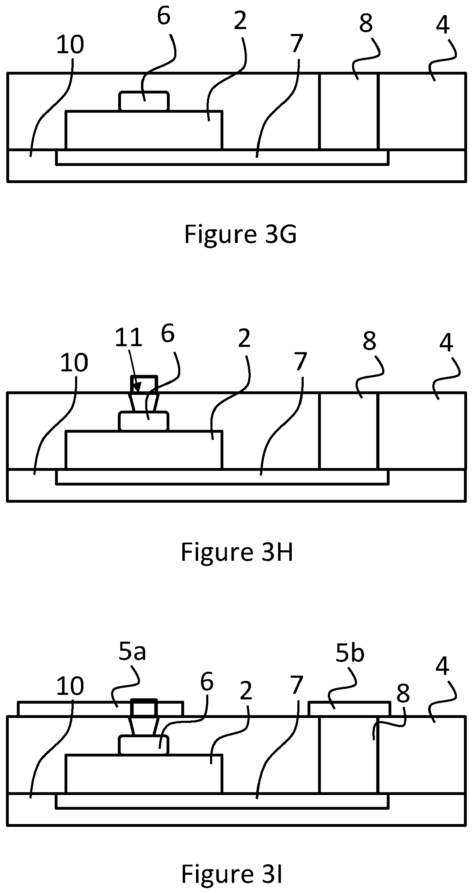

Next, a process of manufacturing electronic package 1a is described with reference to Figures 3A-3I.

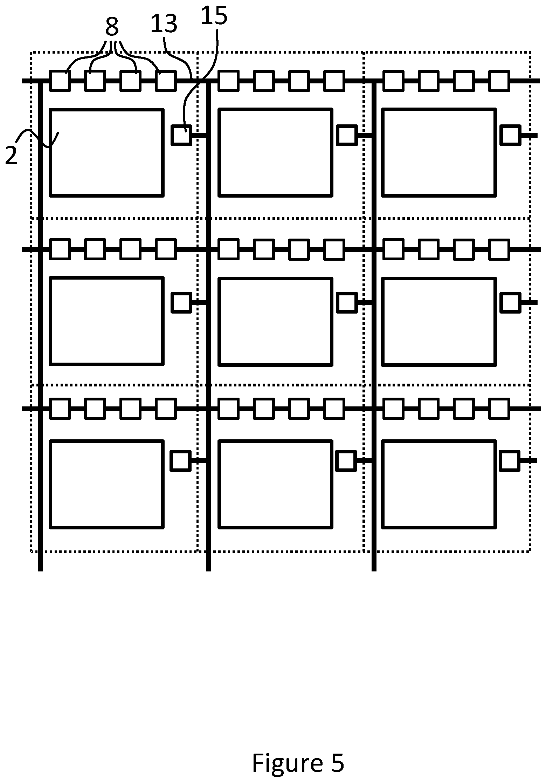

First, in Figure 3A, a carrier substrate 9 is provided on which semiconductor die 2 and conductive element 8 are arranged. As detailed above, semiconductor die 2 may comprise a conductive stud 6 forming the terminal at first surface 3a of semiconductor die 2 that is electrically connected to the first circuit terminal (not shown). It is noted that no die attach material is needed, since semiconductor die 2 is fixated by placing it on carrier substrate 9. As such, semiconductor die 2 also does not require a backside metal layer prior to the manufacturing process. Furthermore, a relative position between semiconductor die 2 and conductive element 8 can be advantageously used as a means of registering a location of semiconductor die 2 during the manufacturing process. This will be described in further detail with reference to Figure 3G and Figure 5.

Here, it is noted that semiconductor die 2 could also be arranged on the carrier in a flip-chip configuration. For example, semiconductor die 2 may comprise conductive bumps at a bottom surface thereof that are electrically connected to a corresponding terminal, and semiconductor die 2 may be arranged on carrier substrate 9 with said conductive bumps facing carrier substrate 9. The ensuing description below therefore similarly applies to a flip-chip configuration.

Next, in Figure 3B, a molding process is performed by applying a molding compound and allowing said molding compound to solidify, thereby forming body of solidified molding compound 4 that encapsulates semiconductor die 2 and conductive element 8. At this stage, carrier substrate 9 functions as a temporary carrier that supports the molding compound until it is sufficiently solidified.

As described above, conductive element 8 may have alternative dimensions and shapes, such as a T-shape, a triangular shape, a trapezoidal shape, or the like. In particular, conductive element 8 may exhibit mold-lock features when it has an irregular cross-section along its length L as indicated in Figure 2A.

In the ensuing portion of the manufacturing process, bottom side processing and top side processing of the structure shown in Figure 3B will be described. In particular, bottom side processing may include the steps shown in Figures 3C-3F, while top side processing may include the steps shown in Figures 3G-3I. Here, although bottom side processing is described prior to top side processing, it is noted that the present disclosure is not limited to such order of steps. For example, top side processing and bottom side processing may be performed substantially simultaneously or in an interleaved manner, or either of top side processing and bottom side processing is performed or initiated first.

In Figure 3C, after body of solidified molding compound 4 is formed, carrier substrate 9 is removed, thereby exposing a bottom surface of conductive element 8 and second surface 3b of semiconductor die 2.

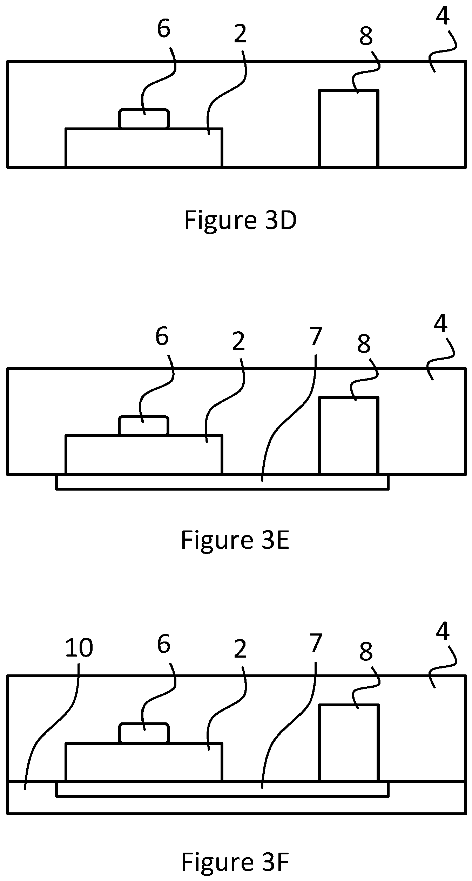

Further, in Figure 3D, a bottom side of the structure is optionally grinded to reduce a thickness of semiconductor die 2 and an overall thickness of the eventual electronic package. In an example, the bottom side of the structure is grinded uniformly. In some embodiments, grinding the bottom side removes a portion of each of semiconductor die 2, body of solidified molding compound 4 and conductive element 8. Second surface 3b of semiconductor die 2 may be substantially level with the bottom side of body of solidified molding compound 4 and the bottom surface of conductive element 8. It can be particularly advantageous to reduce the thickness of semiconductor die 2 at this stage rather than simply using thin semiconductor dies, which can be difficult to transport and may require a special pre-assembling process and specialized machinery to handle without substantially reducing the yield due to increased risk of breaking. However, the present disclosure is not limited to grinding the bottom side, and the step shown in Figure 3C may instead be skipped.

Next, in Figure 3E, a conductive layer 7 is formed at the bottom side of the structure to electrically connect the second terminal at second surface 3b of semiconductor die 2 to conductive element 8. For example, a seed layer (not shown) is arranged and a (e.g., copper) plating process is performed to form conductive layer 7. The seed layer may for example be arranged as a blanket layer, and prior to or after the plating process a portion of the seed layer and, if applicable, a portion of the formed conductive layer 7 may be etched away. Alternatively, the seed layer is deposited using a mask, in which case an etching step may not be performed. The plating process may correspond to electroplating.

Subsequently, in Figure 3F, conductive layer 7 is optionally covered using a cover material 10, such as a protective film or (solidified) molding compound. Cover material 10 may for example be arranged to protect conductive layer 7 from external damages, such as mechanical stress, thermal stress, corrosion, or the like.

In Figure 3G, the top side of the structure is grinded to thereby expose a top surface of conductive element 8. At this stage, it can be advantageous if, for example in Figure 3B, conductive element 8 extends further from carrier substrate 9 than semiconductor die 2 (including conductive stud 6) does. In that case, upon grinding the top side and exposing the top surface of conductive element 8, semiconductor die 2 remains encapsulated in body of solidified molding compound 4. In doing so, a mechanical stress applied to semiconductor die 2 is limited during the grinding process, while also minimizing the amount of time spent etching, cutting or drilling body of solidified molding compound, which may otherwise be a more time-consuming process. The grinding process may be applied uniformly at the top side. Furthermore, the grinding process may additionally remove a portion of conductive element 8 if the grinding process is continued after conductive element 8 is exposed. After the grinding process, the top side of body of solidified molding compound 4 and the top surface of conductive element 8 may be substantially level.

Next, in Figure 3H, since conductive stud 6 of semiconductor die 2 is not yet exposed, the top side processing further comprises removing a portion of body of solidified molding compound 6, thereby forming a recess 11 therein. For example, a laser drilling step and/or a plasma etch step may be performed to expose a portion of conductive stud 6.

Finally, in Figure 31, a first package terminal 5a and a second package terminal 5b are formed at the top side of body of solidified molding compound 4. First package terminal 5a is electrically connected to conductive stud 6 or directly to the corresponding terminal at the first surface of semiconductor die 2 in absence of conductive stud 6. Second package terminal 5b is electrically connected to conductive element 8, and is electrically connected to the corresponding terminal at the second surface of semiconductor die 2 through conductive layer 7 and conductive element 8. As shown in Figure 31, first package terminal 5a and second package terminal 5b enable access to the terminals of semiconductor die 2 at a same side of the electronic package. The electronic package is configured to be mounted to an external surface, such as a PCB, with first package terminal 5a and second package terminal 5b facing said external surface.

First package terminal 5a and/or second package terminal 5b may be formed by arranging a seed layer (not shown) on top of body of solidified molding compound 4 and applying an plating process, such as electroplating. The seed layer may for example be a copper alloy, and the plating may for example be copper. The seed layer may for example be arranged as a blanket layer, and prior to or after the plating process a portion of the seed layer and, if applicable, a portion of the formed first package terminal 5a and/or second package terminal 5b may be etched away. Alternatively, the seed layer is deposited using a mask, in which case an etching step may not be performed. For further solderability, a solder layer (e.g., tin) may be provided through another plating process, such as through another electroplating process.

Here, it is noted that the present disclosure is not limited to the above steps or indicated sequence of steps. For example, the molding compound may be molded such that body of solidified molding compound 4 only partially encapsulates semiconductor die 2 or conductive element 8, for example leaving first surface 3a of semiconductor die 2 (or a top surface of conductive stud 6) and/or the top surface of conductive element 8 exposed. Depending on the surfaces left exposed after the molding process, the step shown in one or both of Figures 3G and 3H may not be needed. Furthermore, as described above, top side processing and bottom side processing may be performed in any order, or may be performed simultaneously.

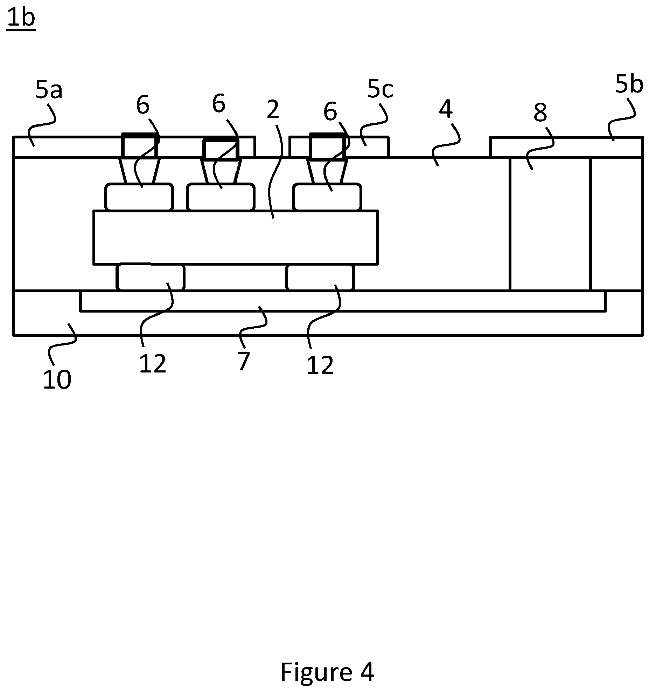

In Figure 4, a cross-section of an electronic package 1b according to an embodiment of the present disclosure is shown. Electronic package 1b differs from electronic package 1 in Figures 2A and 2B in that electronic package 1b comprises a semiconductor die 2 having a three-terminal device integrated thereon. For example, the three-terminal device may be a transistor, such as a bipolar junction transistor (BJT) or a field-effect transistor (FET). As such, semiconductor die 2 may have a gate terminal and a source terminal arranged at the first surface thereof, and may have a drain terminal arranged at the second surface thereof. Each terminal may have an associated package terminal. For example, the source terminal may be electrically connected to first package terminal 5a, and the drain terminal may be electrically connected to second package terminal 5b through conductive layer 7 and conductive element 8. The gate terminal is electrically connected to a third package terminal 5c arranged at a same side of electronic package 1b as first and second package terminals 5a, 5b.

Electronic package 1b further differs from electronic package 1 in that a plurality of conductive studs 6 are provided for the source terminal. However, the present disclosure is not limited thereto, and electronic package 1b could instead comprise no conductive studs, only one conductive stud, or more than two conductive studs. In addition, conductive studs 6 need not be provided for a specific circuit terminal. Furthermore, Figure 4 shows a flip-chip configuration in which, during manufacturing, semiconductor die 2 was placed on top of the carrier substrate (not shown) with a plurality of conductive bumps 12 facing said carrier substrate. conductive bumps 12 are electrically connected to the drain terminal, in this case.

Here, it is noted that other configurations are also envisaged in the present disclosure. For example, the drain terminal and the source terminal could be swapped, such that the source terminal is electrically connected to second package terminal 5b through conductive layer 7 and conductive element 8 and, if applicable, conductive bumps 12.

Furthermore, instead of a three-terminal device, semiconductor die 2 may have a circuit integrated thereon comprising even more circuit terminals. Each circuit terminal may be electrically connected to a corresponding package terminal, either directly or through a conductive stud, or, in so far as being arranged on the second surface of semiconductor die 2, through a respective conductive layer and a respective conductive element.

In addition, although not shown in Figure 4, first package terminal 5a may be electrically connected to corresponding conductive stud(s) 6 via an intermediate layer, such as a seed layer. Similarly, second package terminal 5b may be electrically connected to conductive element 8 via an intermediate layer, such as a seed layer. Furthermore, third package terminal 5c may be electrically connected to corresponding conductive stud(s) 6 via an intermediate layer, such as a seed layer.

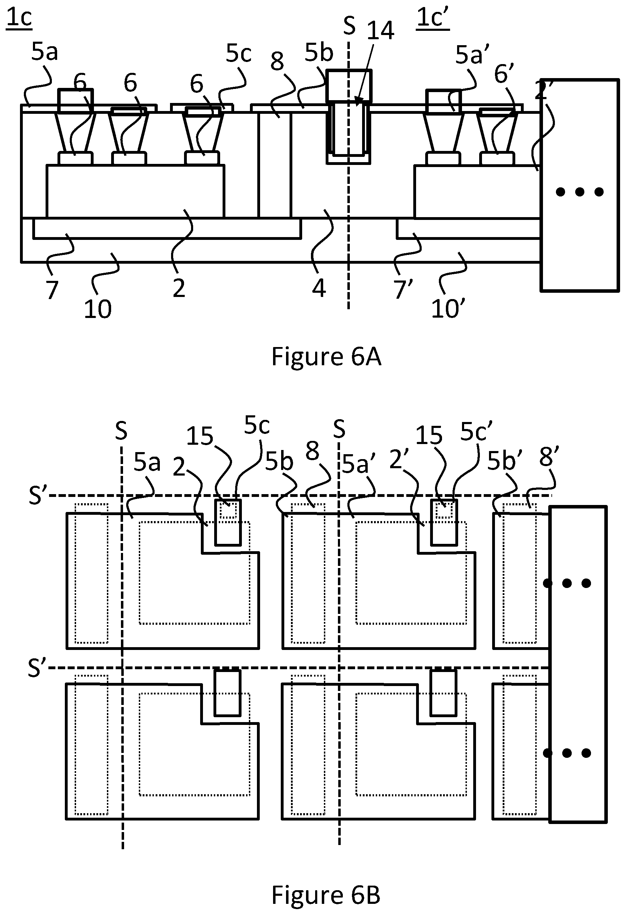

Next, a process for manufacturing a plurality of electronic packages substantially simultaneously is described with reference to Figures 5, 6A and 6B. It is noted that several process steps described with reference to Figures 3A-3I may similarly apply to the process for manufacturing multiple electronic packages simultaneously. For convenience, a detailed description thereof is therefore omitted.

In Figure 5, a top view during a step of the manufacturing process for manufacturing a plurality of electronic packages is shown. This step may be similar to the step shown in Figure 3A. In particular, instead of a single semiconductor die and conductive element, a plurality of semiconductor dies 2 and a plurality of conductive elements 8 are arranged on top of a carrier substrate (not shown). The package portions of each electronic package during this step are indicated with dashed lines. The dashed lines also indicate a line along which a singulation step would be performed for separating the plurality of electronic packages from one another.

Electronic packages according to the present disclosure have one or more conductive element 8 associated with its semiconductor die 2. In Figure 5, four conductive elements 8 are provided for each semiconductor die 2. If a plurality of conductive elements 8 are arranged for each semiconductor die 2, then said conductive elements 8 may be electrically connected to one another via a conductive interconnecting element 13, such as a tie bar.

The plurality of conductive elements 8 of each package portion may also be electrically connected to one another via interconnecting lines 13, such as tie bars, as shown in Figure 5. In other words, conductive elements 8 may be conveniently provided in a grid or frame, allowing for simplified placement on the carrier substrate.

Moreover, semiconductor dies 2 may be arranged on the carrier substrate and can be aligned based on the grid or frame formed by conductive elements 8 and interconnecting lines 13. As a result, when semiconductor die 2 is encapsulated in molding compound, its location (and the location of terminals of semiconductor die 2) can more easily be located with respect to the grid or frame of conductive elements 8.

Interconnecting lines 13 may serve as a bus line during electroplating for forming package terminals of the electronic package. Furthermore, each package portion may further comprise a further conductive element 15 that is also connected to the grid or frame of conductive elements via an interconnecting line, as described further below with reference to Figures 6A and 6B.

During a later step, similar to Figure 3B, a molding compound is arranged. However, when manufacturing a plurality of electronic packages, molding compound may be arranged for a plurality of package portions rather than a single portion at a time. This greatly improves the manufacturing speed of the electronic packages.

Similarly, top side processing and bottom side processing for each package portion may be performed substantially simultaneously. In particular, interconnecting elements 13 form a bus line for the electroplating process, enabling the forming of a plurality of package terminals for each package portion substantially simultaneously.

Preferably, a singulation step is performed after top side processing and bottom side processing, such that the individual electronic packages are obtained immediately after singulation. However, it is also envisaged that top side processing and bottom side processing is performed separately on a smaller portion of the plurality of packages, or individually on each package.

In Figure 6A, a cross-sectional view is shown of an electronic package 1c and an electronic package 1c' after top side and bottom side processing, but prior to singulation. Figure 6B illustrates a corresponding top view of electronic packages, including electronic package 1c and electronic package 1c', prior to singulation. Electronic package 1c and electronic package 1c' each comprise a semiconductor die 2 that is not arranged in a flip-chip manner, and that has a three-terminal device integrated thereon, similar to the embodiment shown in Figure 4. Further features of electronic package 1c and electronic package 1c' are similar to electronic package 1a of Figure 2A and/or electronic package 1b of Figure 4, and a detailed description thereof is omitted.

After top side and bottom side processing, a singulation step can be performed by a singulation step the electronic packages along dashed line S. The singulation step may comprise, for example, drilling, punching, etching, sawing, or the like, to separate the plurality of electronic packages, including electronic package 1c and electronic package 1c', from one another.

As shown in Figure 6A, during top side processing, second package terminal 5b of electronic package 1c and first package terminal 5a' of electronic package 1c' may be formed using a single conductive layer, though the present disclosure is not limited thereto. Since electronic packages 1c, 1c' will be singulated along dashed line S, the physical connection between second package terminal 5b and first package terminal 5a' will be broken after singulation. Initially forming said package terminals as a single layer can simplify the manufacturing process by reducing a number of distinct steps to be performed.

Moreover, during top side processing, a recess 14 may be formed in body of solidified molding compound 4 such that second package terminal 5b of electronic package 1c and first package terminal 5a' of electronic package 1c' are arranged at least on a respective side wall of said recess 14 after singulation. This configuration enables forming a side-wettable flank for each electronic package, which may be beneficial in various applications, such as automotive applications, as automated optical inspection tools can more easily detect the solder joint reliability after soldering the electronic package to an external surface. However, the present disclosure is not limited thereto, and recess 14 may instead be omitted in some embodiments.

As shown in Figure 6B, the plurality of electronic packages may be formed in a two-dimensional (2D) array. In that case, singulation along dashed lines S may be performed in a first direction and along dashed lines S' in a second direction. Here, it is noted that, for convenience, the interconnecting elements 13 of Figure 5 are not shown in Figure 6B

Further to the above, during top side processing, the forming of third package terminal 5c, 5c' could also be combined with forming first package terminal 5a, 5a' and second package terminal 5b, 5b', respectively. In particular, a further conductive element 15 may be provided that is also connected to the grid or frame of conductive elements via an interconnecting line (not shown). As such, further conductive element 15 is also connected to the bus line, and an electroplating step for forming third package terminal 5c, 5c' can be combined with forming first and second package terminals 5a, 5a', 5b, 5b'.

Third package terminal 5c, 5c' may correspond to a third terminal of semiconductor die 2, which may be arranged at the top surface or the bottom surface of semiconductor die 2. For example, if the third terminal is arranged at the top surface, then further conductive element 15 may be used to form third package terminal 5c through electroplating. In another example, if the third terminal is arranged at the bottom surface (not shown), then further conductive element 15 may additionally serve as an electrical connection extending between a bottom side of body of solidified molding compound 4 and a top side of body of solidified molding compound 4. In the latter case, third package terminal 5c may be formed to be electrically connected to further conductive element 15, similarly to conductive element 8 for second package terminal 5b.

Although not shown in Figure 6A, first package terminals 5a, 5a' may be electrically connected to corresponding conductive stud(s) 6, 6' via an intermediate layer, such as a seed layer. Similarly, second package terminals 5b, 5b' may be electrically connected to conductive element 8 (not shown for package 1c') via an intermediate layer, such as a seed layer. Furthermore, third package terminals 5c, 5c' may be electrically connected to corresponding conductive stud(s) 6, 6' via an intermediate layer, such as a seed layer.

The ensuing description above provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including various modifications and/or combinations of features from different embodiments, without departing from the scope of the present disclosure as defined by the appended claims.

## Claims

1. A method for manufacturing an electronic package (1a; 1b; 1c; 1c'), the method comprising the steps of:
a) providing a carrier substrate (9) having arranged thereon:
a semiconductor die (2) having a first surface and an opposing second surface, the semiconductor die (2) having a circuit integrated thereon, wherein each of the first surface and the second surface has a respective terminal arranged thereat, the terminals being electrically connected to the circuit, and wherein the second surface is arranged facing the carrier substrate (9); and
a conductive element (8) spaced apart from the semiconductor die (2) and having a top surface and a bottom surface, wherein the bottom surface is arranged facing the carrier substrate (9);
b) applying a molding compound and allowing said molding compound to solidify, thereby forming a body of solidified molding compound (4) that at least partially encapsulates the semiconductor die (2) and the conductive element (8), said body of solidified molding compound (4) having a top side facing the first surface and a bottom side facing the second surface; and
c) performing top side processing and bottom side processing,
wherein top side processing comprises:
c11) in so far as the top surface of the conductive element (8) and/or the terminal at the first surface of the semiconductor die (2) is encapsulated by the body of solidified molding compound (4), removing a portion of the body of solidified molding compound (4) for exposing said top surface or terminal, respectively; and
c12) forming a first package terminal (5a) at the top side that is electrically connected to the terminal at the first surface, and forming a second package terminal (5b) at the top side that is electrically connected to the top surface of the conductive element (8);
wherein bottom side processing comprises:
c21) removing the carrier substrate (9) to expose the bottom side of the body of solidified molding compound (4), the second surface, and the bottom surface of the conductive element (8); and
c22) arranging a conductive layer (7) for connecting the bottom surface of the conductive element (8) to the terminal arranged on the second surface of the semiconductor die (2).

2. The method according to claim 1, wherein the terminal arranged at the first surface of the semiconductor die (2) comprises one or more conductive studs (6); and/or
wherein the body of solidified molding compound (4) fully encapsulates the semiconductor die (2), and wherein step c11) comprises removing a first portion of the body of solidified molding compound (4) at the top side to enable forming the first package terminal (5a) electrically connected to the terminal at the first surface of the semiconductor die (2), wherein removing the first portion of the body of solidified molding compound (4) is preferably performed by laser drilling or plasma etching.

3. The method according to any of the previous claims, wherein the body of solidified molding compound (4) fully encapsulates the conductive element (8), and wherein step c11) comprises removing a second portion of the body of solidified molding compound (4) at the top side to enable forming the second package terminal (5b) electrically connected to said conductive element (8),
wherein a length of said conductive element (8), along a direction from the bottom surface thereof to the top surface thereof, is preferably greater than a thickness of the semiconductor die (2) along said direction,
wherein, preferably, removing the second portion of the body of solidified molding compound (4) is performed by grinding the top side, thereby exposing a portion of said conductive element (8) at the top side, and wherein removing the second portion of the body of solidified molding compound (4) is more preferably performed before removing the first portion of the body of solidified molding compound (4), or wherein removing the second portion of the body of solidified molding compound (4) is preferably performed by laser drilling or plasma etching.

4. The method according to any of the previous claims, wherein forming the first package terminal (5a) and the second package terminal (5b) comprises arranging one or more corresponding intermediate layers (16) such as seed layers, and performing an electroplating process; and/or
wherein, prior to step c22) during bottom side processing, the method further comprises grinding the bottom side, thereby removing a portion of the semiconductor die (2) at a side of the second surface thereof; and/or
wherein bottom side processing further comprises:
c23) arranging a cover material (10) encapsulating the conductive layer (7), wherein the cover material (10) is preferably formed using a molding compound or a solder mask.

5. The method according to any of the previous claims, wherein the carrier substrate (9) has arranged thereon a plurality of groups, each group comprising a respective semiconductor die (2; 2') and a respective conductive element (8), for substantially simultaneously manufacturing a plurality of electronic packages (1c, 1c'), wherein the plurality of groups are arranged in a mutually spaced apart manner,
wherein the method further comprises a step of singulating the plurality of electronic packages (1c, 1c') from one another, wherein the step of singulating the plurality of electronic packages (1c, 1c') preferably comprises performing at least one of cutting, sawing, punching and drilling.

6. The method according to claim 5, wherein the conductive elements (8) from the plurality of groups are arranged in a frame or grid, wherein the conductive element (8) of each group is electrically connected to one or more conductive elements (8) from one or more respective adjacent groups through conductive interconnection elements (13), such as tie bars,
wherein, during the step of singulating the plurality of electronic packages (1c, 1c'), the electrical connection formed by the conductive interconnection elements (13) is broken.

7. The method according to claim 5 or 6, wherein, during step c12), each of the first and second package terminal (5b) corresponding to a respective electronic package (1c) among the plurality of electronic packages (1c, 1c') is integrally formed with and/or electrically connected to a first package terminal (5a) or second package terminal (5b) corresponding to an adjacent electronic package (1c') among the plurality of electronic packages (1c, 1c'),
wherein, during the step of singulating the plurality of electronic packages (1c, 1c'), the electrical connection between package terminals of the adjacently arranged electronic packages is broken,
wherein, preferably:
the method further comprises forming one or more recesses (14) in the body of solidified molding compound (4) in a region in between adjacently arranged electronic packages (1c, 1c'),
the first package terminal (5a) and/or second package terminal (5b), or the electrical connection between package terminals of adjacently arranged electronic packages (1c, 1c'), extends along a side wall of a corresponding recess (14) among the one or more recesses (14), and
the singulation of the plurality of electronic packages (1c, 1c') is performed along the one or more recesses (14).

8. The method according to any of the previous claims, wherein the conductive element (8) comprises a metal or metal-coated post or pillar, such as a copper or copper-coated post or pillar; and/or
wherein the conductive element (8), when viewed in a direction from the bottom surface to the top surface, has a substantially constant or increasing cross-sectional area along said direction; and/or
wherein the first package terminal (5a), the second package terminal (5b) and/or the conductive layer (7) comprise at least one of copper, aluminum, silver, gold, and tin, the method preferably further comprising plating the first package terminal (5a) and/or the second package terminal (5b) with a conductive solderable layer, such as tin, through an electroplating process; and/or
wherein the circuit integrated on the semiconductor die (2) comprises:
a diode, having a first terminal arranged at the first surface of the semiconductor die (2) and having a second terminal arranged at the second surface of the semiconductor die (2); or
a transistor, having a first and third terminal thereof arranged at the first surface of the semiconductor die (2), and having a second terminal thereof arranged at the second surface of the semiconductor die (2), wherein top side processing further comprises removing a portion of the body of solidified molding compound (4) for exposing said third terminal, and forming a third package terminal (5c) at the top side that is electrically connected to the third terminal at the first surface.

9. An electronic package (1a; 1b; 1c; 1c'), comprising:
a semiconductor die (2) having a first surface and an opposing second surface, the semiconductor die (2) having a circuit integrated thereon, wherein each of the first surface and the second surface has a respective terminal arranged thereat, the terminals being electrically connected to the circuit;
a conductive element (8) spaced apart from the semiconductor die (2) and having a top surface and a bottom surface;
a body of solidified molding compound (4) at least partially encapsulating the semiconductor die (2) and the conductive element (8), said body of solidified molding compound (4) having a top side facing the first surface and a bottom side facing the second surface;
a first package terminal (5a) at the top side that is electrically connected to the terminal at the first surface, and a second package terminal (5b) at the top side that is electrically connected to the conductive element (8); and
a conductive layer (7) electrically connecting the bottom surface of the conductive element (8) to the terminal arranged at the second surface of the semiconductor die (2),
wherein the conductive element (8) is separately formed from the second package terminal (5b) and the conductive layer (7).

10. The electronic package (1a; 1b; 1c; 1c') according to claim 9, wherein the second package terminal (5b) is electrically connected to the conductive element (8) via an intermediate layer (16) and/or wherein the first package terminal (5a) is electrically connected to the terminal at the first surface via an intermediate layer (16),
wherein the intermediate layer is preferably a seed layer comprising a different material composition compared to at least one of the conductive element (8), the first package terminal (5a) and the second package terminal (5b), wherein more preferably the first package terminal (5a) and/or the second package terminal (5b) are electroplated terminals.

11. The electronic package (1a; 1b; 1c; 1c') according to claim 9 or 10, wherein the terminal arranged at the first surface of the semiconductor die (2) comprises one or more conductive studs (6).

12. The electronic package (1a; 1b; 1c; 1c') according to any of the claims 9-11,
wherein a length of said conductive element (8), along a direction from the bottom surface thereof to the top surface thereof, is greater than a thickness of the semiconductor die (2) along said direction; and/or
wherein the electronic package (1a; 1b; 1c; 1c') further comprises a cover material (10) encapsulating the conductive layer (7), wherein the cover material (10) is preferably comprises a solidified molding compound or a solder mask; and/or
wherein the electronic package (1a; 1b; 1c; 1c') further comprises one or more interconnection elements (13) extending from the conductive element (8) to a side surface of the electronic package (1a; 1b; 1c; 1c').

13. The electronic package (1a; 1b; 1c; 1c') according to any of the claims 9-12,
wherein the first and/or second package terminal (5b) extends along a side wall of the body of solidified molding compound (4), said side wall preferably extending perpendicularly between the top side and the bottom side.

14. The electronic package (1a; 1b; 1c; 1c') according to any of the claims 9-13,
wherein the conductive element (8) comprises a metal or metal-coated post or pillar, such as a copper or copper-coated post or pillar; and/or
wherein the conductive element (8), when viewed in a direction from the bottom surface to the top surface, has a substantially constant or increasing cross-sectional area along said direction.

15. The electronic package (1a; 1b; 1c; 1c') according to any of the claims 9-14,
wherein the first package terminal (5a), the second package terminal (5b) and/or the conductive layer (7) comprise at least one of copper, aluminum, silver, gold, and tin, wherein the first package terminal (5a) and/or the second package terminal (5b) are preferably plated with a conductive solderable layer, such as tin; and/or
wherein the circuit integrated on the semiconductor die (2) comprises:
a diode, having a first terminal arranged at the first surface of the semiconductor die (2) and having a second terminal arranged at the second surface of the semiconductor die (2); or
a transistor, having a first and third terminal thereof arranged at the first surface of the semiconductor die (2), and having a second terminal thereof arranged at the second surface of the semiconductor die (2), the electronic package comprising a third package terminal (5c) at the top side that is electrically connected to the third terminal at the first surface.
